(19) **Europäisches Patentamt / European Patent Office / Office européen des brevets**

(11) **EP 4 757 519 A1**

(12) **EUROPEAN PATENT APPLICATION**
published in accordance with Art. 153(4) EPC

(43) Date of publication:
**10.06.2026 Bulletin 2026/24**

(21) Application number: **24849139.1**

(22) Date of filing: **29.07.2024**

(51) International Patent Classification (IPC):
**H05K 9/00** $^{(2006.01)}$

(52) Cooperative Patent Classification (CPC):
**H05K 9/00**

(86) International application number:
**PCT/JP2024/026981**

(87) International publication number:
**WO 2025/028488 (06.02.2025 Gazette 2025/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.08.2023 JP 2023127290**

(71) Applicant: **Maxell, Ltd.
Kyoto 618-8525 (JP)**

(72) Inventors:
• **HIROI, Toshio
Kyoto 618-8525 (JP)**
• **HIROSE, Takehito
Kyoto 618-8525 (JP)**

(74) Representative: **Mewburn Ellis LLP
Aurora Building
Counterslip
Bristol BS1 6BX (GB)**

(54) **ELECTROMAGNETIC WAVE ABSORBER**

(57)    It is possible to obtain an electromagnetic-wave absorber that can favorably absorb electromagnetic waves with high frequencies in or above the millimeter-wave band, and that can favorably absorb electromagnetic waves with a desired frequency even when the ambient temperature has changed. Provided is an electromagnetic-wave absorber containing, in a binder 1b, magnetoplumbite-type hexagonal ferrite 1a that magnetically resonates in a millimeter-wave frequency band, wherein a portion of metal sites of the magnetoplumbite-type hexagonal ferrite is substituted with La, and in a graph showing a relationship between the frequency of an incident electromagnetic wave and a value of a complex relative permeability imaginary part of the electromagnetic-wave absorber, when the temperature of the electromagnetic-wave absorber has changed from 25°C to 105°C, a frequency value at which a positive peak is present indicates a positive percentage change, and a ratio of a change amount of the frequency at which the positive peak is present when the temperature has changed from 25°C to 105°C, to a frequency value at which the positive peak is present at 25°C is 1.5% or less.

FIG. 1

EP 4 757 519 A1

**Description**

Technical Field

The present disclosure relates to an electromagnetic-wave absorber for absorbing electromagnetic waves, and in particular relates to an electromagnetic-wave absorber that suppresses fluctuations in the frequency of absorbed electromagnetic waves caused by temperature changes and can favorably absorb electromagnetic waves having a desired frequency even in an environment in which temperature changes.

Background Art

In order to avoid the influence of leakage electromagnetic waves emitted to the outside from electrical circuits or the like, and undesirably reflected electromagnetic waves, electromagnetic-wave absorbing compositions that absorb electromagnetic waves are used. An electromagnetic-wave absorbing composition is molded into a predetermined shape as an electromagnetic-wave absorbing member such as a block-shaped electromagnetic-wave absorber or a sheet-shaped electromagnetic-wave absorbing sheet, and is also known to be used as an electromagnetic-wave absorbing paint that is applied to desired locations.

In recent years, research on techniques utilizing higher frequency electromagnetic waves, including electromagnetic waves in a centimeter-wave band to a millimeter-wave band, and an even higher frequency band above the millimeter-wave band, has proceeded for mobile communications such as mobile phones, wireless LAN, and the electronic toll collection system (ETC). In response to the trend of techniques utilizing higher frequency electromagnetic waves, there is growing demand for electromagnetic-wave absorbers for absorbing unnecessary electromagnetic waves to absorb electromagnetic waves in the millimeter-wave band of approximately 30 GHz to 300 GHz, or in higher frequency bands.

As electromagnetic-wave absorbers (sheets) for absorbing electromagnetic waves in a high frequency band in or above the millimeter-wave band, a sheet in which a resin binder contains epsilon iron oxide and hexagonal ferrite has been proposed to suppress changes in the frequency of the electromagnetic waves absorbed when the ambient temperature changes (see Patent Document 1).

Prior Art Documents

Patent Document

[Patent Document 1] JP 2019-145534A

Disclosure of Invention

Problem to be Solved by the Invention

The electromagnetic-wave absorbing sheet described in Patent Document 1 contains, in a binder, hexagonal ferrite, whose coercive force increases when the ambient temperature rises and in which the peak frequency of the electromagnetic waves absorbed accordingly shifts to a higher value, and epsilon iron oxide, whose coercive force decreases when the ambient temperature rises and in which the frequency of the electromagnetic waves absorbed accordingly shifts to a lower value. This allows effects of the frequency shifts in the electromagnetic waves absorbed when the ambient temperature changes to cancel each other out, allowing the sheet to exhibit favorable electromagnetic-wave absorbing properties over a wide temperature range.

However, the conventional electromagnetic-wave absorbing sheets have posed challenges in requiring low-cost electromagnetic-wave absorbing sheets, such as the need for epsilon iron oxide particles in addition to hexagonal ferrite, which increases material costs, and the need to uniformly mix and disperse hexagonal ferrite particles that have a relatively large particle size and are flat, with epsilon iron oxide particles, which are spherical and have small iron oxide particles with an average particle size of 50 nm, in a binder.

In order to solve such conventional problems, this disclosure aims to obtain an electromagnetic-wave absorber that can favorably absorb electromagnetic waves with high frequencies in or above the millimeter-wave band, and that can favorably absorb electromagnetic waves with a desired frequency even when the ambient temperature changes.

Means for Solving Problem

In order to solve the above problems, the electromagnetic-wave absorber disclosed in this application is an electromagnetic-wave absorber containing, in a binder, magnetoplumbite-type hexagonal ferrite that magnetically resonates in a millimeter-wave frequency band, wherein a portion of metal sites of the magnetoplumbite-type hexagonal ferrite is substituted with La, and in a graph showing a relationship between a frequency of an incident electromagnetic wave and a value of a complex relative permeability imaginary part of the electromagnetic-wave absorber, when a temperature of the electromagnetic-wave absorber has changed from 25°C to 105°C, a frequency value at which a positive peak is present indicates a positive percentage change, and a ratio of a change amount of the frequency at which the positive peak is present when the temperature has changed from 25°C to 105°C, to a frequency value at which the positive peak is present at 25°C is 1.5% or less.

Effects of the Invention

The electromagnetic-wave absorber disclosed in this application has the above configuration, and therefore electromagnetic-wave absorbing properties change little with a change in the ambient temperature, and the electromagnetic-wave absorber can favorably absorb electromagnetic waves having a desired frequency even in an environment in which a temperature change occurs.

Brief Description of Drawings

[FIG. 1] FIG. 1 is a schematic diagram illustrating a schematic configuration of an electromagnetic-wave absorbing sheet according to this embodiment.
[FIG. 2] FIG. 2 is a diagram showing a relationship between the frequency of electromagnetic waves of an electromagnetic-wave absorbing sheet of Example 2 and the value of a complex relative permeability imaginary part of the electromagnetic-wave absorber.
[FIG. 3] FIG. 3 is a diagram showing a relationship between the frequency of electromagnetic waves and a transmission attenuation amount per unit thickness in the electromagnetic wave absorbing sheet of Example 2.
[FIG. 4] FIG. 4 is a diagram showing a relationship between the frequency of electromagnetic waves of an electromagnetic-wave absorbing sheet of Comparative Example 1 and the value of the complex relative permeability imaginary part of the electromagnetic-wave absorber.
[FIG. 5] FIG. 5 is a diagram showing a relationship between the frequency of electromagnetic waves and the transmission attenuation amount per unit thickness of the electromagnetic-wave absorbing sheet of Comparative Example 1.
[FIG. 6] FIG. 6 is a diagram showing a relationship between the change amount of the value of the complex relative permeability imaginary part and the amount of increase in the thickness required to ensure the electromagnetic-wave absorption amount required at 105°C.

Description of the Invention

The electromagnetic-wave absorber disclosed in this application is an electromagnetic-wave absorber containing, in a binder, magnetoplumbite-type hexagonal ferrite that magnetically resonates in a millimeter-wave frequency band, wherein a portion of metal sites of the magnetoplumbite-type hexagonal ferrite is substituted with La, in a graph showing a relationship between the frequency of incident electromagnetic waves and a value of a complex relative permeability imaginary part of the electromagnetic-wave absorber, when the temperature of the electromagnetic-wave absorber has changed from 25°C to 105°C, a frequency value at which a positive peak is present indicates a positive percentage change, and a ratio of a change amount of a frequency at which the positive peak is present when the temperature has changed from 25°C to 105°C, to a frequency value at which the positive peak is present at 25°C is 1.5% or less.
Here, the wording "ratio of a change amount of a frequency at which the positive peak is present when the temperature has changed from 25°C to 105°C, to a frequency value at which the positive peak is present at 25°C" refers to a numerical value represented by a formula (1) below, where $f_{25}$ represents the frequency at which the positive peak is present at 25°C, $\mu'_{25}$ represents the value of the complex relative permeability imaginary part at that time, $f_{105}$ represents the frequency at which the positive peak is present at 105°C, and $\mu'_{105}$ represents the value of the complex relative permeability imaginary part at that time.

$$(f_{105}-f_{25})/f_{25}\times100 \qquad (1)$$

Also, the above metal sites contain at least one type of barium (Ba), strontium (Sr), and calcium (Ca).

By doing this, electromagnetic-wave absorbing properties of the electromagnetic-wave absorber disclosed in this application change little with a change in the ambient temperature, and the electromagnetic-wave absorber can favorably absorb electromagnetic waves having a desired frequency even when the ambient temperature has changed.

Preferably, in the electromagnetic-wave absorber disclosed in this application, in the graph showing the relationship between the frequency of incident electromagnetic waves and the value of a complex relative permeability imaginary part of the electromagnetic-wave absorber, the value of the complex relative permeability imaginary part at the positive peak indicates a negative percentage change when the temperature of the electromagnetic-wave absorber has changed from 25°C to 105°C, and the ratio of the change amount of the value of the complex relative permeability imaginary part at the positive peak when the temperature has changed from 25°C to 105°C, to the value of the complex relative permeability imaginary part that reaches a positive peak at 25°C is 15% or less.

Note that the wording "ratio of the change amount of the value of the complex relative permeability imaginary part at a positive peak when the temperature has changed from 25°C to 105°C, to the value of the complex relative permeability imaginary part that reaches the positive peak at 25°C" refers to a numerical value represented by a formula (2) below, when $f_{25}$ represents the frequency at which the positive peak is present at 25°C, $\mu''_{25}$ represents the value of the complex relative permeability imaginary part at that time, $f_{105}$ represents the frequency at which the positive peak is present at 105°C, and $\mu''_{105}$ represents the value of the complex relative permeability imaginary part at that time.

$$(\mu''_{105} - \mu''_{25})/\mu''_{25} \times 100 \qquad (2)$$

This makes it possible to reduce the change in the value of the complex relative permeability imaginary part caused by a temperature change, and therefore it is possible to favorably absorb electromagnetic waves with a desired frequency even when the ambient temperature has changed.

In addition, it is preferable that the amount of La substitution (x) of the metal sites of the magnetoplumbite-type hexagonal ferrite is 0.1 or more and 0.57 or less. This makes it possible to take advantage of the effect of reducing the amount of change in electromagnetic-wave absorbing properties with respect to temperature changes caused by La substitution.

Further, it is preferable that, at a frequency at which the positive peak is present in the graph showing the relationship between the frequency of the incident electromagnetic waves and the value of the complex relative permeability imaginary part of the electromagnetic-wave absorber when the temperature of the electromagnetic-wave absorber is 25°C, the absolute value of the ratio of the change amount of the value of the complex relative permeability imaginary part when the temperature of the electromagnetic-wave absorber has changed from 25°C to 105°C, to the value of the complex relative permeability imaginary part at 25°C is 14% or less.

Here, the wording "at a frequency at which the positive peak is present in the graph showing the relationship between the frequency of the incident electromagnetic waves and the value of the complex relative permeability imaginary part of the electromagnetic-wave absorber when the temperature of the electromagnetic-wave absorber is 25°C, the absolute value of the ratio of the change amount of the value of the complex relative permeability imaginary part when the temperature of the electromagnetic-wave absorber has changed from 25°C to 105°C, to the value of the complex relative permeability imaginary part at 25°C" refers to a numerical value represented by a formula (3) below, when $f_{25}$ represents the frequency at which the positive peak is present at 25°C, $\mu''_{23}$ represents the value of the complex relative permeability imaginary part at that time, and $\mu''_{105\,(f25)}$ represents the value of the complex relative permeability imaginary part at the frequency $f_{25}$ at 105°C.

$$(\mu''_{105(f25)} - \mu''_{25})/\mu''_{25} \text{ (absolute value)} \times 100 \qquad (3)$$

By doing this, when the temperature has changed from 25°C to 105°C, a decrease in the value of the complex relative permeability imaginary part at the peak frequency at 25°C is reduced, and a change in electromagnetic-wave absorbing properties depending on temperature is reduced. In addition, it is possible to reduce the percentage of an increase in thickness when improving electromagnetic-wave absorbing properties by increasing the thickness of the electromagnetic-wave absorber.

Furthermore, it is preferable that, in the graph showing the relationship between the frequency of the incident electromagnetic wave and the value of the complex relative permeability imaginary part of the electromagnetic-wave absorber, the full width at half maximum when the temperature of the electromagnetic-wave absorber is 25°C and the full width at half maximum when the temperature of the electromagnetic-wave absorber is 105°C are both 8.5 GHz or more. By doing this, even when the electromagnetic-wave absorber is used as an electromagnetic-wave absorber in a device related to 79 GHz onboard millimeter-wave radars with a wide frequency range set at 4 GHz, it is possible to ensure an electromagnetic-wave absorption frequency band sufficient for practical use.

In addition, it is preferable that the frequency value at which the positive peak is present in the graph showing the relationship between the frequency of the incident electromagnetic wave and the value of the complex relative permeability imaginary part of the electromagnetic-wave absorber is 75 GHz or more and 80 GHz or less. By doing this, the electromagnetic-wave absorber can be suitably used as an electromagnetic-wave absorber for use in an onboard radar for automobiles whose market as a practical field is expanding.

At least any one of rubber, plastic, and a thermoplastic elastomer can be suitably used as a binder for the electromagnetic-wave absorber.

It is also preferable that the electromagnetic-wave absorber further contains, as a permittivity adjusting agent, conductive carbon black or at least one selected from the group consisting of furnace conductive carbon black, acetylene black, and ketjenblack.

Furthermore, it is preferable that the electromagnetic-wave absorber includes at least an electromagnetic-wave absorbing layer and a layer having an electromagnetic-wave surface reflection suppression function, and is in the form of a sheet with an overall thickness of 2 mm or less, and the overall thickness of the electromagnetic-wave absorber is 1 mm or less.

In addition, it is preferable that the content of the magnetoplumbite-type hexagonal ferrite in the electromagnetic-wave absorber is 89% by mass or less.

The AEC (Automotive Electronics Council), which is a standards organization for the reliability of onboard electronic components, specifies that the upper limit of the operating temperature range is set at 125°C in Grade 1 of the AEC-Q101 (integrated circuit) category in the AEC standards. Therefore, in this application, absorbing properties of the electromagnetic-wave absorber were specified in the temperature range from 25°C, which is room temperature, to 125°C, which is the upper limit of the operating temperature range. In other words, a small change in the electromagnetic-wave absorbing properties even when the temperature changes from 25°C to 105°C is a benchmark for improving the reliability of onboard electronic components.

Hereinafter, the electromagnetic-wave absorber disclosed in this application will be described by using an electromagnetic-wave absorbing sheet formed in a sheet shape having a small thickness relative to the area thereof.

(Embodiments)

[Electromagnetic-wave absorbing sheet]

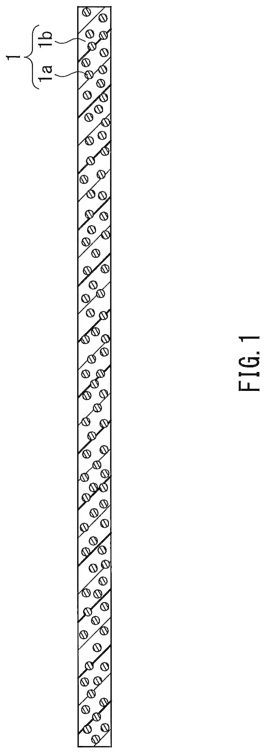

FIG. 1 is a cross-sectional view illustrating a configuration of an electromagnetic-wave absorbing sheet 1 according to this embodiment.

Note that FIG. 1 is a diagram for facilitating understanding of a configuration of the electromagnetic-wave absorbing sheet according to this embodiment, and the sizes and thicknesses of components shown in the diagram are not representative of reality.

The electromagnetic-wave absorbing sheet 1 described in this embodiment as an example includes magnetoplumbite-type hexagonal ferrite 1a and a resin binder 1b. The magnetoplumbite-type hexagonal ferrite 1a used in the electromagnetic-wave absorbing sheet according to this embodiment has a structure in which a portion of metal sites such as a strontium (Sr) or barium (Ba) site is substituted with lanthanum (La).

FIG. 1 shows the sheet 1 including the binder 1b, and the sheet 1 contains a dispersant for favorably dispersing the magnetoplumbite-type hexagonal ferrite 1a in the resin binder 1b.

[Magnetoplumbite-type hexagonal ferrite]

The electromagnetic-wave absorbing sheet 1 according to this embodiment contains, in the binder, powder of the magnetoplumbite-type hexagonal ferrite 1a in which a portion of metal sites is substituted with lanthanum (La).

The magnetoplumbite-type hexagonal ferrite 1a, in which a portion of the metal sites has been substituted with lanthanum and the iron (Fe) site has been substituted with aluminum (Al), is represented by a general formula: $A_{(1-x)}La_xFe_{(n-y)}Al_y$, where A that represents the metal site is one or more selected from the group consisting of Sr (strontium), Ba (barium), and Ca (calcium), and requirements $0.01 \leq x \leq 0.57$, $1.00 \leq y \leq 2.20$, and $11.00 \leq n \leq 12.50$ are met.

Here, the ratio represented by the general formula of the atomic ratio of the above metal elements refers to the atomic ratio of the metal atoms contained in a single-phase crystal structure of the magnetoplumbite-type hexagonal ferrite magnetic powder, and each metal element is substituted to the Fe site and A, which represents a metal site, as a constituent element of the magnetoplumbite-type crystal structure. It is known that if the metal elements mixed as raw materials during metal substitution do not undergo substitution to the respective sites of the magnetoplumbite-type hexagonal ferrite and remain outside of it in a different form, the magnetic powder mixture that is ultimately obtained will have a frequency that is significantly outside a desired absorption frequency.

The magnetoplumbite-type hexagonal ferrite 1a in which a portion of metal sites has been substituted with La is preferable because electromagnetic-wave absorbing properties change little with temperature changes. In particular, a change in the frequency of the electromagnetic-wave absorption peak caused by a temperature change can be suppressed. In order to achieve the effect of being less susceptible to the above temperature change due to the substitution with La, a substitution amount x of La indicated in the above general formula is more preferably 0.1 or more and 0.57 or less.

The content of the magnetoplumbite-type hexagonal ferrite 1a in the electromagnetic-wave absorbing sheet mentioned in this embodiment is preferably 89% by mass or less, and more preferably 85.2% by mass or less, relative to the total content including the content of the binder 1b, carbon black serving as a permittivity adjusting agent described later, and the like. As the content of the magnetic material increases, a change in the transmission attenuation amount, which indicates the percentage of electromagnetic waves absorbed when a temperature change occurs, increases. By setting a mass content of magnetoplumbite-type hexagonal ferrite 1a to 89% by mass or less, it is possible to set, to 6.5% or less, the percentage change in the transmission attenuation amount for the electromagnetic wave with a frequency at which the absorption peak is obtained at 25°C when the temperature of the electromagnetic-wave absorbing sheet 1 changes from 25°C to 105°C, resulting in the electromagnetic-wave absorbing sheet 1 in which a decrease in the transmission attenuation amount caused by a temperature change is small.

[Binder]

In the electromagnetic-wave absorbing sheet 1 according to this embodiment, it is preferable to use, as the resin binder 1b, at least one selected from rubber, plastic, and a thermoplastic elastomer.

It is possible to use, as a rubber binder, natural rubber (NR), isoprene rubber (IR), butadiene rubber (BR), styrene-butadiene rubber (SBR), butyl rubber (IIR), nitrile rubber (NBR), ethylene-propylene rubber (EPDM), chloroprene rubber (CR), acrylic rubber (ACM), chlorosulfonated polyethylene rubber (CSR), urethane rubber (PUR), silicone rubber (Q), fluororubber (FKM), ethylene vinyl acetate rubber (EVA), epichlorohydrin rubber (CO), polysulfide rubber (T), urethane rubber (U), or the like.

It is possible to use, as plastic, a thermosetting resin or a thermoplastic resin. It is possible to use, as a thermosetting resin, a phenolic resin, a urea resin, a melamine resin, an epoxy resin, an unsaturated polyester resin, an alkyd resin, a silicone resin, a polyurethane, or the like. It is possible to use, as a thermoplastic resin, polyethylene, polypropylene, polystyrene, ABS resin, poly(methyl methacrylate), polyvinyl chloride, polyamide, polyethylene terephthalate, polybutylene terephthalate, polycarbonate, or the like.

It is possible to use, as a thermoplastic elastomer, a styrene-based thermoplastic elastomer (SIS, styrene-isoprene copolymer, SBS, styrene-butadiene copolymer), an olefin-based thermoplastic elastomer, a urethane-based thermoplastic elastomer, a polyester-based thermoplastic elastomer, or the like.

[Other materials]

The electromagnetic-wave absorbing sheet 1 according to this embodiment may include members other than the magnetoplumbite-type hexagonal ferrite 1a and the resin binder 1b.

As a result of the electromagnetic-wave absorbing sheet 1 containing the permittivity adjusting agent, the permittivity of the electromagnetic-wave absorbing sheet 1 can easily take a desired value. By increasing the permittivity of the electromagnetic-wave absorbing sheet 1, the electromagnetic-wave absorption performance can be improved due to the dielectric loss effect. In addition, adjusting the permittivity enables matching with the characteristic impedance and suppression of the reflection of electromagnetic waves at any thickness.

It is possible to use, as a permittivity adjusting agent, a carbon material such as carbon black, carbon nanotubes, or carbon nanostructures, barium titanate, a conductive polymer, or a metal wire. In particular, carbon black is preferable as a permittivity adjusting agent for the following reasons: first, it is less likely to develop electrical anisotropy in the TD/MD directions after sheet molding; second, it also functions as a reinforcing material for a rubber binder and plastics; and third, it is inexpensive and readily available. If the shape of the permittivity adjusting agent is anisotropic, anisotropy, which changes electromagnetic-wave absorbing properties depending on the direction of incident to the electromagnetic-wave absorbing sheet, occurs. Therefore, it is preferable to use particulate carbon black as the permittivity adjusting agent rather than needle-shaped or rod-shaped carbon black, such as carbon nanotubes. More specifically, it is possible to suitably use various conductive carbon blacks such as furnace conductive carbon black, acetylene black, and ketjenblack.

It is possible to use particulate carbon black with a specific surface area of 30 to 2300 $m^2/g$, preferably with a specific surface area of 300 to 2000 $m^2/g$, and more preferably with a specific surface area of 800 to 1800 $m^2/g$.

When carbon black is contained as a permittivity adjusting agent, the content thereof is preferably less than 4.5%, and more preferably 3.0% or less, relative to the total mass of the electromagnetic-wave absorbing sheet. If the electromagnetic-wave absorbing sheet 1 contains carbon black in an amount of 4.5% or more, the change in the peak frequency of the absorbed electromagnetic waves due to temperature changes will be large, and the percentage change of the frequency at which the transmission attenuation amount peaks when the temperature of the electromagnetic-wave absorbing sheet 1 changes from 25°C to 105°C will be larger than 1.5%, making it difficult to realize an electromagnetic-wave absorbing sheet with a small change in the transmission attenuation rate at a predetermined frequency with respect to temperature changes.

In addition, the electromagnetic-wave absorbing sheet 1 may contain various dispersants. It is possible to use, as a dispersant, a compound having a polar group such as a phosphate group, a sulfonic group, or a carboxy group.

It is possible to use, as a phosphate compound having a phosphate group, an arylphosphonic acid such as phenylphosphonic acid or phenylphosphonic dichloride, an alkylphosphonic acid such as methylphosphonic acid, ethylphosphonic acid, octyl phosphonic acid, or propylphosphonic acid, or a polyfunctional phosphonic acid such as hydroxyethane diphosphonic acid or nitrotrismethylenephosphonic acid. Moreover, it is possible to use, as a compound having a polar group such as a carboxy group, an aliphatic carboxylic acid having 12 to 18 carbon atoms, such as caprylic acid, capric acid, lauric acid, myristic acid, palmitic acid, stearic acid, behenic acid, oleic acid, elaidic acid, linoleic acid, linolenic acid, or stearolic acid.

The electromagnetic-wave absorbing sheet 1 can be produced using a known kneading method using, for example, a batch kneader, a roll mill, a continuous kneader, or the like. When the material of the electromagnetic-wave absorbing sheet 1 requires vulcanization, for example, a known method using a hot press or rotocure (continuous vulcanizing machine) can be used as appropriate. In addition, when the material of the electromagnetic-wave absorbing sheet 1 requires secondary vulcanization, for example, a known method using a far-infrared vulcanization furnace (continuous type) can be used as appropriate. If no vulcanizing agent is used, cross-linking can be carried out using electron beam cross-linking or gamma-ray cross-linking as appropriate. Other methods for forming the electromagnetic-wave absorbing sheet 1 include injection molding, extrusion, rolling, and thermal cross-linking, which can be used when the binder is a rubber material. In addition, the electromagnetic-wave absorbing sheet 1 can be formed using ball mills, bead mills, or the like through dispersion together with a binder material such as rubber or plastic in various organic solvents, alcohol, water, or the like, and then applying the dispersion onto a predetermined base using a coating method such as comma coating, gravure coating, or die coating.

[Other configurations]

In addition, in the electromagnetic-wave absorber according to this embodiment, an adhesive layer can be provided on a face opposite to the electromagnetic-wave incident surface.

By providing the adhesive layer, the electromagnetic-wave absorbing sheet can be easily attached to a predetermined location. The adhesive layer can be easily formed by applying an adhesive resin paste. An acrylic adhesive agent, a rubber adhesive agent, a silicone adhesive agent, or the like can be used as the material for the adhesive layer. Adhesive tape such as acrylic adhesive tape or silicone adhesive tape can also be used for the adhesive layer.

In addition, a reflective layer may be provided on the back side of the electromagnetic-wave absorber in a view from the electromagnetic-wave incident surface. By providing the reflective layer, it is possible to reliably shield from and absorb electromagnetic waves in a high frequency band in or above the millimeter-wave band. It is possible to use, as the reflective layer, a metal foil, a metal vapor deposition film, a composite film formed by attaching an aluminum foil and a polyester film together, a mesh-like conductor, silver nanowires (Ag-NWs), a conductive polymer film, or the like.

Further, an electromagnetic-wave reflection suppressing layer may be provided on the electromagnetic-wave incident side of the electromagnetic-wave absorber. The electromagnetic-wave reflection suppressing layer contains a binder, and the proportion of the binder is greater than the proportion of the binder contained in the electromagnetic-wave absorber. A rubber binder, a thermoplastic resin, or a thermosetting resin can be used as the binder. In this way, by disposing the electromagnetic-wave reflection suppressing layer between an air layer and the electromagnetic-wave absorber, the relative permittivity is reduced from the air layer side toward the electromagnetic-wave absorbing layer in order, and the difference between the relative permittivity of the air layer and the relative permittivity of the electromagnetic-wave reflection suppressing layer decreases. Therefore, it is possible to suppress the reflection of the electromagnetic waves incident from the electromagnetic-wave reflection suppressing layer side, and thus to improve the electromagnetic-wave absorbing properties.

(Examples)

Hereinafter, specific examples will be described in which electromagnetic-wave absorbing sheets were actually produced, and electromagnetic-wave absorbing properties of the electromagnetic-wave absorbing sheets described in this embodiment were measured.

Table 1 shows a list of a configuration of each sheet and the measurement results.

[Table 1]

| | Weight Ratio of Magnetic Material (wt%) | CB Weight Ratio (wt%) | Peak Frequency Percentage Change (%) | Peak Value Percentage Change (%) | Permeability Percentage Change (%) | Full Width at Half Maximum (GHz) | | Attenuation Amount Percentage Change (%) | Thickness Increase Percentage (%) |
| | | | | | | 25°C | 105°C | | |
|---|---|---|---|---|---|---|---|---|---|
| Ex. 1 | 42.6 | 0.0 | 0.6 | 9.4 | 10.4 | 8.4 | 8.4 | 5.3 | 5.6 |
| Ex. 2 | 64.5 | 0.0 | 0.7 | 9.9 | 10.7 | 9.9 | 9.6 | 5.6 | 5.9 |
| Ex. 3 | 79.3 | 0.0 | 0.8 | 11.5 | 12.4 | 9.8 | 9.6 | 5.5 | 5.8 |
| Ex. 4 | 85.2 | 0.0 | 0.9 | 11.9 | 13.1 | 12.3 | 12.3 | 6.4 | 6.8 |
| Ex. 5 | 89.0 | 0.0 | 1.4 | 12.8 | 14.6 | 11.1 | 11.6 | 7.5 | 8.1 |
| Ex. 6 | 89.0 | 0.5 | 1.4 | 14.7 | 15.5 | 13.1 | 12.9 | 6.7 | 7.2 |
| Ex. 7 | 85.2 | 1.5 | 1.4 | 15.5 | 14.9 | 14.3 | 14.2 | 5.8 | 6.2 |
| Ex. 8 | 64.5 | 1.0 | 0.8 | 10.4 | 14.9 | 9.4 | 8.7 | 5.3 | 5.6 |
| Ex. 9 | 64.5 | 2.0 | 1.2 | 14.1 | 14.4 | 13.4 | 13.3 | 4.5 | 4.7 |
| Ex. 10 | 64.5 | 4.0 | 1.5 | 15.0 | 15.0 | 15.7 | 15.6 | 4.3 | 4.5 |
| Comp. Ex. 1 | 64.5 | 0.0 | 2.6 | 15.9 | 35.8 | 7.1 | 7.0 | 20.8 | 26.3 |
| Comp. Ex. 2 | 64.5 | 1.5 | 2.7 | 16.2 | 37.6 | 7.3 | 7.2 | 22.2 | 28.5 |
| Comp. Ex. 3 | 92.5 | 0.0 | 1.9 | 15.0 | 15.0 | 7.8 | 7.8 | 12.5 | 14.3 |

(Production of electromagnetic-wave absorbing sheet)

Strontium ferrite with a Sr site substituted with La, which is represented by the general formula "$A_{(1-x)}La_xFe_{(n-y)}Al_y$", was used as a magnetoplumbite-type hexagonal ferrite contained in the electromagnetic-wave absorbing sheet. The particle size $D_{50}$ was 3.1 $\mu$m, and the volume contents were as shown in Table 1. In Table 1, for the electromagnetic-wave absorbing sheets mentioned as Comparative Example 1 and Comparative Example 2, magnetoplumbite-type hexagonal ferrites in which the Sr site was not substituted with La were used.

Silicone rubber ("KE-951KU: product name" manufactured by Shin-Etsu Chemical Co., Ltd.) was used for the binder.

To these materials, 2.5-dimethyl-2.5-di(t-butylperoxy)hexane ("C-8A: product name" manufactured by Shin-Etsu Chemical Co., Ltd.) as a vulcanizing agent, stearic acid ("Lunac S-50V: product name" manufactured by Kao Corporation) as a processing assistant, and fatty acid amide ("Plastron S: product name" manufactured by "Fuso International Limited) were added. The mixture was then kneaded in a batch kneader at a rotation speed of 35 rpm while cold water flowed to prevent the temperature from rising too much, and was formed into a sheet using a calender to a thickness of 1.5 to 2.0 mm. After vulcanization at 160°C/10 min using a heat press, the sheet was subjected to secondary vulcanization at 200°C/4 Hr in a warm bath to produce a sheet with a thickness of 1.5 to 2.0 mm and a size of 150 mmo (square).

A weight ratio of the binder was 97.1%, a weight ratio of the vulcanizing agent was 0.7%, a weight ratio of the processing assistant was 0.8%, and a weight ratio of the fatty acid amide was 1.5%.

(Measurement method)

For the electromagnetic-wave absorbing sheet, the transmission attenuation amount serving as the electromagnetic-wave absorption amount was measured using the free space method.

The free space measurement was performed using the free space measurement device DPS24-01 (product name) manufactured by Keycom Corporation and the vector network analyzer MS46522B (product name) manufactured by Anritsu Corporation, and using two horn antennas, the produced electromagnetic-wave absorbing sheet sample was irradiated with an input wave (millimeter wave) having a predetermined frequency over a range of 100 mmø via a dielectric lens from the transmitting and receiving antenna. The transmitted waves passing through the sample were measured, the intensity of the input waves was compared with the intensity of the transmitted waves, and the transmission attenuation amount, which is the degree of attenuation, was determined in dB. The obtained transmission attenuation amount (dB) was divided by the actual thickness of the electromagnetic-wave absorbing sheet to determine a transmission attenuation amount in 1 mm thickness (dB/mm). The frequency range was set to 60 GHz to 90 GHz, and 801 measurement points were set up to measure the electromagnetic-wave transmission attenuation amount (S21) at normal incidence. The vector network analyzer was subjected to TRL calibration in advance, and then gate processing in the time domain (gate settings: center was 0 m, span was 9 cm) was performed to remove signals resulting from multiple reflections.

The complex relative permittivity and the complex relative permeability of the electromagnetic-wave absorbing sheet sample were also measured using the free space method in the same manner as above, by irradiating the sample with electromagnetic waves perpendicularly. The complex relative permittivity (real part, imaginary part) and the complex relative permeability (real part, imaginary part) were calculated from the electromagnetic-wave transmitting properties (phase and amplitude) of the electromagnetic-wave absorbing sheet.

The complex relative permittivity was measured by measuring the amplitude and phase of the transmitted electromagnetic wave (S21) at normal incidence in the frequency band from 55 GHz to 65 GHz, and calculating the average complex relative permittivity (real part, imaginary part) using the frequency change method software manufactured by Keycom Corporation.

The complex relative permeability was measured by measuring the amplitude and phase of the transmitted electromagnetic wave (S21) at normal incidence in the frequency band from 60 GHz to 90 GHz, and the complex relative permeability (real part, imaginary part) was calculated from the amplitude, the phase, and the average relative permittivity from 55 GHz to 65 GHz using permeability calculation software manufactured by Keycom Corporation in the same manner as for the permittivity.

The full widths at half maximum of the complex relative permeability imaginary part ($\mu$") and the transmission attenuation amount were set to frequency ranges at intermediate values between the baseline and peak values of the complex relative permeability imaginary part ($\mu$") and the transmission attenuation amount, respectively, where the baseline is the average of the values measured at 60 GHz and 90 GHz at 25°C and 105°C.

(Measurement results)

In Table 1, the term "peak frequency percentage change (%)" refers to the value "$(f_{105} - f_{25})/f_{25} \times 100$" of the

formula (1) above, i.e., a numerical value obtained by dividing, by the numerical value of the peak frequency at 25°C, the magnitude of the change in the frequency at which the value of the complex relative permeability imaginary part ($\mu$") is a peak value, i.e., the extreme value, when the ambient temperature has changed from 25°C to 105°C, in the curve showing the relationship between the frequency of the electromagnetic wave incident on the electromagnetic-wave absorbing sheet and the value of the complex relative permeability imaginary part ($\mu$").

The term "peak value percentage change (%)" refers to the value "($\mu$"$_{105}$ - $\mu$"$_{25}$)/$\mu$"$_{25}$ × 100" of the formula (2) above, i.e., a numerical value obtained by dividing, by the numerical value of the peak of the complex relative permeability imaginary part ($\mu$") at 25°C, the magnitude of the change in the value of the complex relative permeability imaginary part ($\mu$") in the frequency at which the value of the complex relative permeability imaginary part ($\mu$") is a peak value, i.e., the extreme value, when the ambient temperature has changed from 25°C to 105°C, in the curve showing the relationship between the frequency of the electromagnetic wave incident on the electromagnetic-wave absorbing sheet and the value of the complex relative permeability imaginary part ($\mu$").

Furthermore, the term "permeability percentage change (%)" refers to the value "($\mu$"$_{105(f25)}$ - $\mu$"$_{25}$) / $\mu$"$_{25}$ (absolute value) × 100" in the formula (3) above, i.e., the absolute value of a numerical value obtained by taking the value of the complex relative permeability imaginary part ($\mu$") at the frequency at which the value of the complex relative permeability imaginary part ($\mu$") peaks at an ambient temperature of 25°C, i.e., the extreme value in the curve showing the relationship between the frequency of the electromagnetic wave incident on the electromagnetic-wave absorbing sheet and the value of the complex relative permeability imaginary part ($\mu$"), and dividing the magnitude of the change in that value that occurs when the ambient temperature has changed from 25°C to 105°C by the value at 25°C.

Note that the term "attenuation amount percentage change (%)" refers to a numerical value obtained by dividing, by the value of the maximum transmission attenuation amount at 25°C, the amount of a change in the maximum transmission attenuation amount when the ambient temperature has changed from 25°C to 105°C, where the transmission attenuation amount is a peak amount, i.e., the extreme value, in the curve showing the relationship between the frequency of the electromagnetic wave incident on the electromagnetic-wave absorbing sheet and the value of the transmission attenuation amount.

In addition, the term "thickness increase percentage (%)" refers to a numerical value indicating how much the thickness of the electromagnetic-wave absorbing sheet required to achieve a transmission attenuation amount of 6 dB at the electromagnetic-wave absorption peak frequency when the ambient temperature is 105°C has increased from the thickness required when the ambient temperature is 25°C.

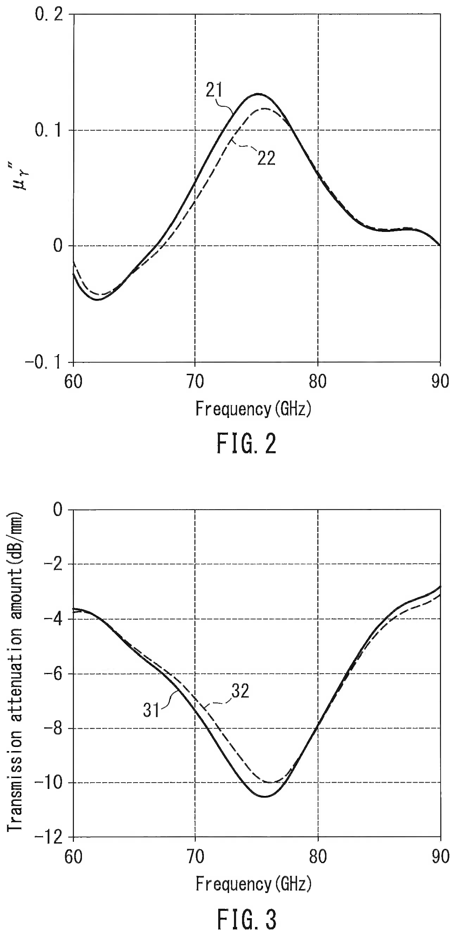

FIG. 2 is a diagram showing a relationship between the frequency of incident electromagnetic waves and the value of the complex relative permeability imaginary part ($\mu$") of the electromagnetic-wave absorbing sheet of Example 2 shown in Table 1.

FIG. 3 is a diagram showing a relationship between the value of the transmission attenuation amount per millimeter of the thickness and a change in the frequency of incident electromagnetic waves in the electromagnetic-wave absorbing sheet of Example 2 also shown in Table 1.

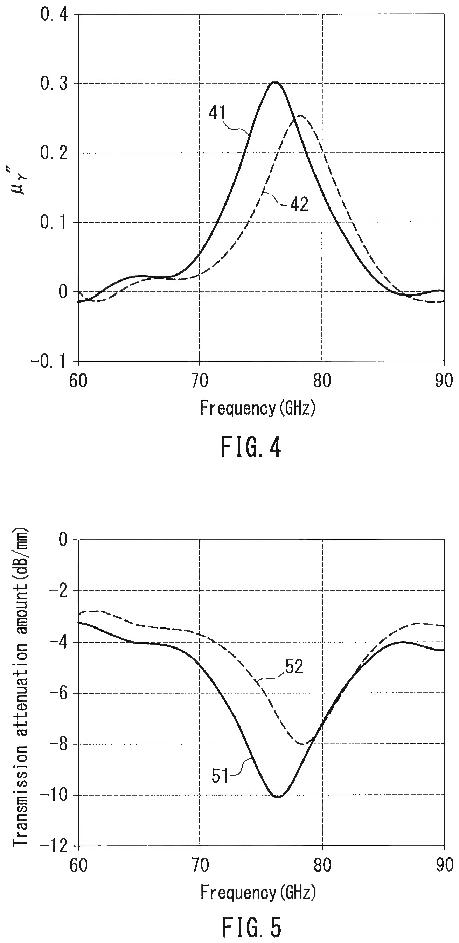

FIG. 4 is a diagram showing a relationship between the frequency of incident electromagnetic waves and the value of the relative permeability imaginary part ($\mu$") of the electromagnetic-wave absorbing sheet of Comparative Example 1 shown in Table 1.

FIG. 5 is a diagram showing a relationship between the value of the transmission attenuation amount per millimeter of the thickness and a change in the frequency of the incident electromagnetic wave in the electromagnetic-wave absorbing sheet of Comparative Example 1 also shown in Table 1.

In the curve indicated by reference numeral 21 in FIG. 2, the curve showing the relationship between the frequency of the incident electromagnetic wave and the value of the complex relative permeability imaginary part ($\mu$") when the ambient temperature of the electromagnetic-wave absorbing sheet of Example 2 is 25°C, a peak (extreme value) is present at a frequency of 75.15 GHz, and the value of the complex relative permeability imaginary part ($\mu$") at this time is 0.131. In the curve indicated by reference numeral 22 in FIG. 2, the curve showing the relationship between the frequency of the incident electromagnetic wave and the value of the complex relative permeability imaginary part ($\mu$") of the electromagnetic-wave absorbing sheet when the ambient temperature of the electromagnetic-wave absorbing sheet of Example 2 is 105°C, a peak (extreme value) is present at a frequency of 75.68 GHz, and the value of the complex relative permeability imaginary part ($\mu$") at this time is 0.118. Therefore, when the ambient temperature has changed from 25°C to 105°C, the change amount of the frequency at which the complex relative permeability imaginary part ($\mu$") peaks is 0.53 GHz, and the peak frequency percentage change for the peak frequency at 25°C is 0.7%. When the ambient temperature has changed from 25°C to 105°C, the change amount of the peak value of the complex relative permeability imaginary part ($\mu$") is 0.013, and the peak value percentage change for the complex relative permeability imaginary part ($\mu$") at 25°C is 9.9%.

The change in the transmission attenuation amount per unit thickness of the electromagnetic-wave absorbing sheet of Example 2 relative to the change in the frequency of the electromagnetic wave is shown in FIG. 3 as a curve indicated by reference numeral 31, the curve showing the relationship between the frequency of the incident electromagnetic wave and the value of the transmission attenuation amount when the ambient temperature is 25°C, and a peak (extreme value) is present at a frequency of 75.64 GHz, and the value of the transmission attenuation amount at this time is -10.405 dB/mm. In the curve indicated by reference numeral 32 in FIG. 3, the curve showing the relationship between the frequency of the incident electromagnetic wave and the value of the transmission attenuation amount when the ambient temperature of the electromagnetic-wave absorbing sheet of Example 2 is 105°C, a peak (extreme value) is present at a frequency of 76.16 GHz, and the value of the transmission attenuation amount at this time is -9.824 dB/mm.

Therefore, when the ambient temperature has changed from 25°C to 105°C, the change amount of the peak value of the transmission attenuation amount between 25°C and 105°C is 0.581 dB/mm, and the percentage change of the transmission attenuation amount relative to the transmission attenuation amount at 25°C is 5.6%. Note that the thickness of the electromagnetic-wave absorbing sheet required to obtain a transmission attenuation amount of 6 dB by using the sheet was calculated from the transmission attenuation amount per millimeter at a frequency of 76.16 GHz at which the transmission attenuation amount peaks at 25°C, and the calculated thickness is 0.577 mm. At this frequency, when the ambient temperature is 105°C, the sheet thickness required to obtain a transmission attenuation amount of 6 dB is 0.610 mm, and when the ambient temperature has changed from 25°C to 105°C, the percentage of an increase in the thickness of the electromagnetic-wave absorbing sheet required to obtain a transmission attenuation amount of 6 dB is 5.9%.

FIGS. 4 and 5 show a relationship between the frequency of electromagnetic waves incident on the electromagnetic-wave absorbing sheet of Comparative Example 1, in which a portion of the Sr site of the magnetoplumbite-type hexagonal ferrite contained in the electromagnetic-wave absorbing sheet is not substituted with La, and the value of the complex relative permeability imaginary part ($\mu$") of the electromagnetic-wave absorbing sheet, as well as a relationship between the frequency of incident electromagnetic waves and the transmission attenuation amount.

In the curve indicated by reference numeral 41 in FIG. 4, the curve showing the relationship between the frequency of the incident electromagnetic wave and the value of the complex relative permeability imaginary part ($\mu$") of the electromagnetic-wave absorbing sheet when the ambient temperature of the electromagnetic-wave absorbing sheet of Comparative Example 1 is 25°C, a peak (extreme value) is present at a frequency of 76.16 GHz, and the value of the complex relative permeability imaginary part ($\mu$") at this time is 0.302. In the curve indicated by reference numeral 42 in FIG. 4, the curve showing the relationship between the frequency of the incident electromagnetic wave and the value of the complex relative permeability imaginary part ($\mu$") of the electromagnetic-wave absorbing sheet when the ambient temperature of the electromagnetic-wave absorbing sheet of Comparative Example 1 is 105°C, a peak (extreme value) is present at a frequency of 78.15 GHz, and the value of the relative permeability imaginary part ($\mu$") at this time is 0.254. Therefore, when the ambient temperature has changed from 25°C to 105°C, the change amount of the frequency at which the complex relative permeability imaginary part ($\mu$") peaks is 1.99 GHz, and the peak frequency percentage change for the peak frequency at 25°C is 2.6%. When the ambient temperature has changed from 25°C to 105°C, the change amount of the peak value of the complex relative permeability imaginary part ($\mu$") is 0.048, and the peak value percentage change for the relative permeability imaginary part ($\mu$") at 25°C is 15.9%.

The change in the transmission attenuation amount per unit thickness of the electromagnetic-wave absorbing sheet of Comparative Example 1 relative to a change in the frequency of the electromagnetic wave has a peak (extreme value) at a frequency of 76.39 GHz, as shown using a curve indicated by reference numeral 51 in FIG. 5, the curve showing the relationship between the frequency of the incident electromagnetic wave and the value of the transmission attenuation amount when the ambient temperature is 25°C, and the value of the transmission attenuation amount per unit thickness at this time is -10.100 dB/mm. Also, in a curve indicated by reference numeral 52 in FIG. 5, the curve showing the relationship between the frequency of the incident electromagnetic wave and the value of the transmission attenuation amount when the ambient temperature of the electromagnetic-wave absorbing sheet of Comparative Example 1 is 105°C, a peak (extreme value) is present at a frequency of 78.58 GHz, and the value of the transmission attenuation amount per unit thickness at this time is -8.001 dB/mm.

Therefore, when the ambient temperature has changed from 25°C to 105°C, the change amount of the peak value of the transmission attenuation amount is 2.099 dB/mm, and the attenuation amount percentage change for the transmission attenuation amount at 25°C is 20.8%. Note that the thickness of the electromagnetic-wave absorbing sheet required to obtain a transmission attenuation amount of 6 dB by using the sheet was calculated from the transmission attenuation amount per millimeter at a frequency of 76.39 GHz at which the transmission attenuation amount peaks at 25°C, and the calculated thickness is 0.594 mm. At this frequency, when the ambient temperature is 105°C, the sheet thickness required to obtain a transmission attenuation amount of 6 dB is 0.750 mm, and when the ambient temperature has changed from 25°C to 105°C, the percentage of an increase in the thickness of the electromagnetic-wave absorbing sheet required to obtain a transmission attenuation amount of 6 dB is 26.3%.

As shown in Table 1, it can be seen that, in the sheets (Examples 1 to 10) in which a portion of metal sites of magnetoplumbite-type hexagonal ferrite is substituted with La, the change in the transmission attenuation amount per unit thickness at the peak frequency at 25°C is 7.5% or less, and the sheets had favorable electromagnetic-wave absorbing properties even when the ambient temperature has changed from 25°C to 105°C.

On the other hand, it can be seen that, in electromagnetic-wave absorption sheets (Comparison Examples 1 and 2) in which a portion of metal sites of magnetoplumbite-type hexagonal ferrite is not substituted with La, the change in the transmission attenuation amount per unit thickness at the peak frequency at 25°C is 20% or more, and the sheets cannot exhibit favorable electromagnetic-wave absorbing properties when the ambient temperature changes from 25°C to 105°C.

It can be seen that, even in the case of the electromagnetic-wave absorbing sheet shown as Comparative Example 3, in which a portion of metal sites of the magnetoplumbite-type hexagonal ferrite is substituted with La, the ratio of the change amount of the complex relative permeability imaginary part ($\mu''$) when the ambient temperature has changed from 25°C to 105°C, to the value of the complex relative permeability imaginary part ($\mu''$) at the peak value at 25°C is 1.9%, which exceeds 1.5%, and the change in the transmission attenuation amount per unit thickness at the peak frequency at 25°C is large at 12.5%, indicating that the sheet cannot exhibit favorable electromagnetic-wave absorbing properties when the ambient temperature changes from 25°C to 105°C.

From the above considerations, it can be seen that requirements for obtaining an electromagnetic-wave absorbing sheet that can favorably absorb electromagnetic waves with a desired frequency even when the ambient temperature has changed are that a portion of metal sites of the magnetoplumbite-type hexagonal ferrite contained in the electromagnetic-wave absorbing sheet is substituted with La and the ratio (permeability percentage change (%)) of the change amount of the relative permeability imaginary part ($\mu''$) when the ambient temperature has changed from 25°C to 105°C to the value of the relative permeability imaginary part ($\mu''$) at the peak value at 25°C is 1.5% or less.

It is conceivable that, as a method for obtaining an electromagnetic-wave absorbing sheet that can favorably absorb electromagnetic waves with a predetermined frequency even when the ambient temperature has changed, the thickness of the electromagnetic-wave absorbing sheet is increased by increasing the amount of magnetoplumbite-type hexagonal ferrite contained in the electromagnetic-wave absorbing sheet. By increasing the thickness of the electromagnetic-wave absorbing sheet at the same volume ratio, the amount of magnetoplumbite-type hexagonal ferrite that absorbs electromagnetic waves increases, improving the electromagnetic-wave absorbing capacity of the electromagnetic-wave absorbing sheet. As a result, even when the electromagnetic-wave absorption amount (absorbing capacity) of the magnetoplumbite-type hexagonal ferrite, which absorbs electromagnetic waves with a predetermined frequency, decreases due to changes in the ambient temperature, the sheet can be designed to be able to favorably absorb electromagnetic waves with a predetermined frequency.

The inventors of the present invention assumed that an electromagnetic-wave absorbing sheet that has a transmission attenuation amount (absolute value) of 6 dB or more as a guideline for the transmission attenuation amount of electromagnetic waves, i.e., an electromagnetic-wave absorbing sheet that absorbs half of the incident electromagnetic waves is designed, understood that the change in the transmission attenuation amount of the electromagnetic-wave absorbing sheet whose transmission attenuation amount peaks at an ambient temperature of 25°C when the ambient temperature is raised to 105°C is the change amount of the value of the relative permeability imaginary part ($\mu''$) of magnetoplumbite-type hexagonal ferrite, and measured the relationship with the percentage of an increase in the thickness required to create an electromagnetic wave absorbing sheet that would obtain a transmission attenuation of 6 dB at the absorption peak frequency at 25°C even at 105°C.

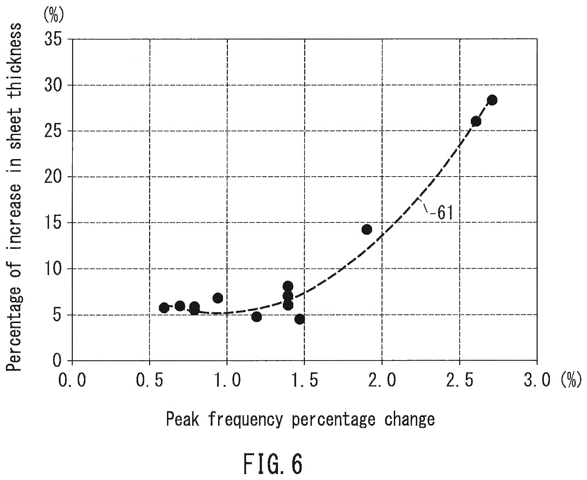

FIG. 6 shows a relationship between the change amount of the value of the complex relative permeability imaginary part and the amount of an increase in the thickness required to ensure the electromagnetic-wave absorption amount required at 105°C.

FIG. 6 is a plot of the "peak frequency percentage change (%)" and the "thickness increase percentage (%)" in the electromagnetic-wave absorbing sheets of Examples 1 to 10 and Comparative Examples 1 to 3 shown in Table 1.

As shown in FIG. 6, it was confirmed that when the ambient temperature has changed from 25°C to 105°C, if the change amount of the frequency at which the relative permeability imaginary part ($\mu''$) peaks is 1.5% or less, the ratio of an increase in the thickness of the electromagnetic-wave absorbing sheet required to absorb electromagnetic waves with that frequency at 105°C changes very little, by 8% or less, whereas when the ambient temperature has changed from 25°C to 105°C, if the change amount of the frequency at which the relative permeability imaginary part ($\mu''$) peaks exceeds 1.5%, the increase in the thickness required increases sharply. For this reason, it was confirmed that even when a method is used in which the thickness of the electromagnetic-wave absorbing sheet is increased to increase the absolute value of the electromagnetic-wave absorption amount by which the electromagnetic-wave absorbing sheet absorbs and obtain an electromagnetic-wave absorbing sheet having favorable electromagnetic-wave absorbing properties even when the ambient temperature has changed, the condition for obtaining an electromagnetic-wave absorbing sheet having favorable electromagnetic-wave absorbing properties is that, when the ambient temperature has changed from 25°C to 105°C, the change amount of the frequency at which the relative permeability imaginary part ($\mu''$) peaks is 1.5% or less.

Furthermore, in the electromagnetic-wave absorbing sheet according to this embodiment, it is preferable that the value of the complex relative permeability imaginary part indicates a percentage change when the temperature has changed from 25°C to 105°C, and that the ratio of the change amount of the value of the complex relative permeability imaginary part when the temperature has changed from 25°C to 105°C to the value of the complex relative permeability imaginary part that reaches a positive peak at 25°C is 15% or less.

Even when the operating temperature of the electromagnetic-wave absorbing sheet changes from 25°C to 105°C, if the change amount of the extreme value of the complex relative permeability imaginary part is small, the change in the electromagnetic-wave absorbing properties will be small. Therefore, in particular, by setting the ratio of the change amount of the value of the complex relative permeability imaginary part when the temperature has changed from 25°C to 105°C to the value of the complex relative permeability imaginary part that reaches the positive peak at 25°C to 15% or less, the sheet can exhibit favorable electromagnetic-wave absorbing properties over a wide temperature range. When the change amount of the extreme value of the complex relative permeability imaginary part exceeds 15%, the change in the electromagnetic-wave absorbing properties due to temperature increases, and the sheet cannot exhibit favorable electromagnetic-wave absorbing properties over a wide temperature range.

Further, it is preferable that, at a frequency at which the positive peak is present at 25°C, the absolute value of the ratio of the change amount of the value of the complex relative permeability imaginary part when the temperature of the electromagnetic-wave absorbing sheet has changed from 25°C to 105°C, to the value of the complex relative permeability imaginary part at 25°C is 14% or less.

At the peak frequency when the temperature is 25°C, by setting the absolute value of the change amount of the value of the complex relative permeability imaginary part when the ambient temperature has changed from 25°C to 105°C to be 14% or less relative to the value at a temperature of 25°C, when the temperature has changed from 25°C to 105°C, the decrease in the complex relative permeability imaginary part at the peak frequency at 25°C becomes smaller, and the change in electromagnetic-wave absorbing properties due to temperature becomes smaller. On the other hand, if the amount of change is greater than 14%, the change in the electromagnetic-wave absorbing properties due to temperature increases, and the sheet cannot exhibit favorable electromagnetic-wave absorbing properties over a wide temperature range.

Furthermore, it is preferable that, with the electromagnetic-wave absorbing sheet according to this embodiment, in the graph showing the relationship between the frequency of the incident electromagnetic wave and the value of the complex relative permeability imaginary part of the electromagnetic-wave absorber, the full width at half maximum when the temperature of the electromagnetic-wave absorber is 25°C and the full width at half maximum when the temperature of the electromagnetic-wave absorber is 105°C are both 8.5 GHz or more.

Since the full widths at half maximum when the temperature of the electromagnetic-wave absorber is 25°C and 105°C are both 8.5 GHz or more, electromagnetic waves over a wider frequency band can be absorbed. As a result, even when the electromagnetic-wave absorbing properties of the electromagnetic-wave absorber have changed due to a temperature change, favorable electromagnetic-wave absorbing properties can be maintained. When the full width at half maximum is smaller than 8.5 GHz, the electromagnetic-wave absorbing properties are significantly affected by temperature changes.

Note that as the thickness of the electromagnetic-wave absorbing sheet increases, the flexibility of the electromagnetic-wave absorbing sheet decreases, making it difficult to arrange the electromagnetic-wave absorbing sheet at a desired position. In particular, recent technological advances have led to a rapid increase in adoption of electromagnetic-wave absorbing sheets for applications such as absorption of unnecessary electromagnetic waves from radar devices installed in automobiles. This requires that electromagnetic-wave absorbing sheets be placed precisely in smaller spaces. In such cases, the thickening of the electromagnetic-wave absorbing sheet is not preferable, including the problem of higher manufacturing costs.

From this point of view, the thickness of the electromagnetic-wave absorbing sheet is preferably 2 mm or less, and more preferably 1 mm or less. In addition, since the frequency of electromagnetic waves used in radars installed in automobiles is 75 GHz or more and 80 GHz or less, the value of the complex relative permeability imaginary part of the electromagnetic-wave absorption sheet is preferably 75 GHz or more and 80 GHz or less.

It was confirmed that when the ambient temperature has changed from 25°C to 105°C, the change in the frequency of the electromagnetic waves, at which the value of the complex relative permeability imaginary part ($\mu''$) of the magnetoplumbite-type hexagonal ferrite peaks, tends to increase when the weight ratio of the magnetoplumbite-type hexagonal ferrite exceeds 80%. Therefore, by setting the weight ratio of magnetoplumbite-type hexagonal ferrite to 90% or less at most, the change amount of the frequency at which the complex relative permeability imaginary part ($\mu'''$) peaks when the ambient temperature has changed from 25°C to 105°C can be kept to a preferable condition of 1.5% or less.

In addition, it was also confirmed that, as the content of carbon black serving as a permittivity adjusting agent contained in the electromagnetic-wave absorbing sheet increases, the change in the frequency of the electromagnetic waves at which the value of the complex relative permeability imaginary part ($\mu''$) of the magnetoplumbite-type hexagonal ferrite peaks when the ambient temperature has changed from 25°C to 105°C increases. Therefore, by setting the content of the permittivity adjusting agent contained in the electromagnetic-wave absorbing sheet to 4.0% or less, the change amount of the frequency at which the complex relative permeability imaginary part ($\mu''$) peaks can be set to a preferable condition of 1.5% or less.

As described above, the electromagnetic-wave absorbing sheet according to this embodiment contains magnetoplumbite-type hexagonal ferrite in which a portion of metal sites is substituted with La, and the frequency value at which a positive peak is present in a graph showing the relationship between the frequency of incident electromagnetic waves and the value of the complex relative permeability imaginary part of the electromagnetic-wave absorber exhibits a positive percentage change when the temperature of the electromagnetic-wave absorber has changed from 25°C to 105°C, and the ratio of the change amount of the frequency at which the positive peak is present when the temperature has changed from 25°C to 105°C, to the frequency value at which the positive peak is present at 25°C is 1.5% or less, thus obtaining an electromagnetic-wave absorbing sheet that can favorably absorb electromagnetic waves with a desired frequency even when the ambient temperature has changed.

Although an electromagnetic-wave absorbing sheet with a thinner thickness relative to its area is mentioned as an example in the above embodiment, the electromagnetic-wave absorber disclosed in this application can be realized as a so-called block-shaped electromagnetic-wave absorber having a certain thickness relative to its area. By satisfying the same requirements as those of the electromagnetic-wave absorbing sheet, it is possible to realize an electromagnetic-wave absorber that exhibits little change in the electromagnetic-wave absorption amount with respect to temperature changes and that can favorably absorb electromagnetic waves with a desired frequency.

Industrial Applicability

The electromagnetic-wave absorber disclosed in the present application contains magnetoplumbite-type hexagonal ferrite in which a portion of metal sites is substituted with La, and the frequency value at which a positive peak is present in the graph showing the relationship between the frequency of incident electromagnetic waves and the value of the complex relative permeability imaginary part of the electromagnetic-wave absorber exhibits a positive percentage change when the temperature of the electromagnetic-wave absorber has changed from 25°C to 105°C, and the ratio of the change amount of the frequency at which the positive peak is present when the temperature has changed from 25°C to 105°C, to the frequency value at which the positive peak is present at 25°C is 1.5% or less, thus realizing an electromagnetic-wave absorber that can favorably absorb electromagnetic waves with a desired frequency even when the ambient temperature has changed. Therefore, for example, the electromagnetic-wave absorber is useful as an electromagnetic-wave absorber for absorbing unnecessary electromagnetic waves in onboard radars mounted on automobiles, for example.

The electromagnetic-wave absorbing sheet disclosed in this application can contribute to reaching Goal 9 (build resilient infrastructure, promote inclusive and sustainable industrialization and foster innovation) of the 17 Sustainable Development Goals (SDGs) established by the United Nations.

Description of Reference Numerals

1    Electromagnetic-wave absorbing sheet (electromagnetic-wave absorber)
1a   Magnetoplumbite-type hexagonal ferrite
1b   Binder

**Claims**

**1.** An electromagnetic-wave absorber comprising

magnetoplumbite-type hexagonal ferrite that magnetically resonates in a millimeter-wave frequency band, the magnetoplumbite-type hexagonal ferrite being contained in a binder,
wherein a portion of metal sites of the magnetoplumbite-type hexagonal ferrite is substituted with La, and
in a graph showing a relationship between a frequency of an incident electromagnetic wave and a value of a complex relative permeability imaginary part of the electromagnetic-wave absorber, when a temperature of the electromagnetic-wave absorber has changed from 25°C to 105°C, a frequency value at which a positive peak is present indicates a positive percentage change, and a ratio of a change amount of the frequency at which the positive peak is present when the temperature has changed from 25°C to 105°C, to a frequency value at which the positive peak is present at 25°C is 1.5% or less.

**2.** The electromagnetic-wave absorber according to claim 1,
wherein, in the graph showing the relationship between the frequency of the incident electromagnetic wave and the value of the complex relative permeability imaginary part of the electromagnetic-wave absorber, the value of the complex relative permeability imaginary part at the positive peak indicates a negative percentage change when the temperature of the electromagnetic-wave absorber has changed from 25°C to 105°C, and a ratio of a change amount of the value of the complex relative permeability imaginary part at the positive peak when the temperature has changed from 25°C to 105°C, to the value of the complex relative permeability imaginary part that reaches a positive peak at 25°C is 15% or less.

3. The electromagnetic-wave absorber according to claim 1 or 2,
wherein an amount of La substitution (x) of the metal sites of the magnetoplumbite-type hexagonal ferrite is 0.1 or more and 0.57 or less.

4. The electromagnetic-wave absorber according to any one of claims 1 to 3,
wherein, at a frequency at which the positive peak is present in the graph showing the relationship between the frequency of the incident electromagnetic wave and the value of the complex relative permeability imaginary part of the electromagnetic-wave absorber when the temperature of the electromagnetic-wave absorber is 25°C, an absolute value of the ratio of a change amount of the value of the complex relative permeability imaginary part when the temperature of the electromagnetic-wave absorber has changed from 25°C to 105°C, to the value of the complex relative permeability imaginary part at 25°C is 14% or less.

5. The electromagnetic-wave absorber according to any one of claims 1 to 4,
wherein, in the graph showing the relationship between the frequency of the incident electromagnetic wave and the value of the complex relative permeability imaginary part of the electromagnetic-wave absorber, a full width at half maximum when the temperature of the electromagnetic-wave absorber is 25°C and a full width at half maximum when the temperature of the electromagnetic-wave absorber is 105°C are both 8.5 GHz or more.

6. The electromagnetic-wave absorber according to any one of claims 1 to 5,
wherein, in the graph showing the relationship between the frequency of the incident electromagnetic wave and the value of the complex relative permeability imaginary part of the electromagnetic-wave absorber, the frequency value at which the positive peak is present is 75 GHz or more and 80 GHz or less.

7. The electromagnetic-wave absorber according to any one of claims 1 to 6,
wherein the binder of the electromagnetic-wave absorber is at least one of rubber, plastic, and a thermoplastic elastomer.

8. The electromagnetic-wave absorber according to any one of claims 1 to 7, further comprising
conductive carbon black as a permittivity adjusting agent.

9. The electromagnetic-wave absorber according to any one of claims 1 to 7, further comprising
at least one selected from the group consisting of furnace conductive carbon black, acetylene black, and ketjenblack, as a permittivity adjusting agent.

10. The electromagnetic-wave absorber according to any one of claims 1 to 9,
wherein the electromagnetic-wave absorber includes at least an electromagnetic-wave absorbing layer and a layer having an electromagnetic-wave surface reflection suppression function, and is in the form of a sheet with an overall thickness of 2 mm or less.

11. The electromagnetic-wave absorber according to claim 10,
wherein the electromagnetic-wave absorber has an overall thickness of 1 mm or less.

12. The electromagnetic-wave absorber according to any one of claims 1 to 11,
wherein a content of the magnetoplumbite-type hexagonal ferrite in the electromagnetic-wave absorber is 89% by mass or less.

FIG. 1

FIG. 2

FIG. 3

FIG. 4

FIG. 5

FIG. 6

## INTERNATIONAL SEARCH REPORT

| International application No. |
|---|
| **PCT/JP2024/026981** |

| A. | CLASSIFICATION OF SUBJECT MATTER |
|---|---|

*H05K 9/00*(2006.01)i
FI:  H05K9/00 M; H05K9/00 W

According to International Patent Classification (IPC) or to both national classification and IPC

| B. | FIELDS SEARCHED |
|---|---|

Minimum documentation searched (classification system followed by classification symbols)

H05K9/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2023-30020 A (DOWA ELECTRONICS MATERIALS CO., LTD.) 07 March 2023 (2023-03-07) <br> paragraphs [0028]-[0095] | 1, 3, 6-12 |
| A | | 2, 4-5 |
| Y | WO 2020/188927 A1 (FUJIFILM CORPORATION) 24 September 2020 (2020-09-24) <br> paragraphs [0146], [0182] | 1, 3, 6-12 |
| Y | WO 2022/168885 A1 (MAXELL, LTD.) 11 August 2022 (2022-08-11) <br> paragraph [0050] | 8-11 |
| Y | WO 2021/100566 A1 (TORAY INDUSTRIES, INC.) 27 May 2021 (2021-05-27) <br> paragraph [0028] | 10-11 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **10 September 2024** | **24 September 2024** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

# EP 4 757 519 A1

**INTERNATIONAL SEARCH REPORT**
Information on patent family members

International application No.

**PCT/JP2024/026981**

| Patent document cited in search report | | | Publication date (day/month/year) | Patent family member(s) | | | Publication date (day/month/year) |
|---|---|---|---|---|---|---|---|
| JP | 2023-30020 | A | 07 March 2023 | WO | 2022/186060 | A1 | |
| | | | | CN | 116964696 | A | |
| WO | 2020/188927 | A1 | 24 September 2020 | US | 2021/0407715 | A1 | |
| | | | | paragraphs [0348], [0474]-[0476] | | | |
| | | | | EP | 3943451 | A1 | |
| | | | | KR | 10-2021-0116645 | A | |
| | | | | CN | 113574021 | A | |
| WO | 2022/168885 | A1 | 11 August 2022 | EP | 4290995 | A1 | |
| | | | | paragraph [0051] | | | |
| WO | 2021/100566 | A1 | 27 May 2021 | US | 2022/0408618 | A1 | |
| | | | | paragraph [0038] | | | |
| | | | | EP | 4064811 | A1 | |
| | | | | CN | 114731776 | A | |
| | | | | KR | 10-2022-0100869 | A | |

Form PCT/ISA/210 (patent family annex) (July 2022)

21

**REFERENCES CITED IN THE DESCRIPTION**

**Patent documents cited in the description**

- JP 2019145534 A